# EUROPÄISCHE PATENTANMELDUNG

(11) **EP 1 517 434 A1**
(43) Veröffentlichungstag der Anmeldung: **23.03.2005**
(21) Anmeldenummer: 03021258.3
(22) Anmeldetag: 19.09.2003
(51) Int. Cl.: H03B 5/32, H03L 7/00

(54) **Frequenzstabilisierter Oszillator**

(71) Anmelder: SIEMENS AKTIENGESELLSCHAFT, 80333 München (DE)
(72) Erfinder: Nagel, Jörg, 47799 Krefeld (DE)

(57) **Zusammenfassung**

Bei einem Oszillator mit einem Schwingkreis zur Bereitstellung eines Taktsignals (2), einem Schwingquarz (7) zur Frequenzstabilisierung des Schwingkreises, einer digitalen Steuereinrichtung (3) zum Regeln einer Frequenz des Schwingkreises und Mitteln zum Abstimmen der Frequenz des Schwingkreises aufgrund von Steuersignalen (4) von der Steuereinrichtung (3), wird die Aufgabe, seine Mittel zum Abstimmen der Resonanzfrequenz seines Schwingkreises auf einem Halbleiterchip zu integrieren, dadurch gelöst, dass die Mittel zum Abstimmen der Frequenz des Schwingkreises von einer Amplituden-/Phasen-Anpassungseinrichtung (5) gebildet werden, die ein dem Schwingkreis zugeführtes Korrektursignal (6) erzeugt, das von dem Taktsignal (2) abgeleitet ist und dessen Frequenz aufweist und die Steuereinrichtung (3) derart ausgebildet ist, dass sie abhängig von einer Differenz zwischen einer gewünschten Taktfrequenz und einer aktuellen Taktfrequenz (2) Phase und Amplitude des Korrektursignals (6) mittels der Steuersignale bestimmt.

## Beschreibung

Die Erfindung bezieht sich auf einen Oszillator mit einem Schwingkreis zur Bereitstellung eines Taktsignals, einem Schwingquarz zur Frequenzstabilisierung des Schwingkreises, einer digitalen Steuereinrichtung zum Regeln einer Frequenz des Schwingkreises und Mitteln zum Abstimmen der Frequenz des Schwingkreises aufgrund von Steuersignalen von der Steuereinrichtung.

Solche Oszillatoren finden Anwendung bei elektronischen Systemen, die auf einem elektronisch erzeugten Taktsignal basieren. Bei vielen solcher elektronischer Systeme bestehen hohe Ansprüche an eine Frequenzgenauigkeit des Oszillators und einer Konstanz der von ihm gelieferten Taktfrequenz. Zur Erhöhung einer Genauigkeit einer Frequenzausgabe des Oszillators werden üblicherweise Schwingquarze eingesetzt. Gerade bei Telekommunikationsendeinrichtungen, wie Mobiltelefonen, reicht jedoch häufig die Frequenzgenauigkeit üblicher Schwingquarze nicht aus, um die Anforderungen an die Stabilität der bereitgestellten Taktfrequenz zu erfüllen. Vielmehr sind zusätzliche Maßnahmen zur Erhöhung der Genauigkeit erforderlich.

In diesem Zusammenhang ist es bei einem Oszillator der eingangs genannten Art bekannt, die Mittel zum Abstimmen der Frequenz des Schwingkreises in Form einer durch Gleichspannung veränderbaren Kapazitätsdiode (Varaktor) auszuführen. Mit Hilfe der von der Steuereinrichtung gelieferten Steuersignale wird die Kapazität der Kapazitätsdiode derart eingestellt, dass eine von dem Schwingkreis gelieferte Frequenz einem gewünschten Wert entspricht.

Eine alternative Ausführungsform für die Mittel zum Abstimmen der Frequenz des Schwingkreises sieht vor, zusätzliche Festkondensatoren mittels elektronisch steuerbarer Schalter, wie beispielsweise Transistoren, an- bzw. abzuschalten.

Es ist wünschenswert, die Mittel zum Abstimmen der Frequenz des Schwingkreises auf Halbleiterchips zu integrieren. Dies ist jedoch bei den beiden aufgezeigten Alternativen dafür schwierig.

Bei einer Integration von Kapazitätsdioden tritt das Problem auf, dass die für die Herstellung von Halbleiterchips optimierten Materialien und Prozesse nicht die Herstellung von Kapazitätsdioden mit optimalen Eigenschaften zulassen. Dies wirkt sich vor allem im Hinblick auf den erzielbaren Abstimmbereich der von dem Oszillator bereitgestellten Frequenz aus. Außerdem ist bei dem Einsatz von Kapazitätsdioden zum Abstimmen der Frequenz des Schwingkreises zwingend ein Digital-/Analogwandler erforderlich, welcher das digitale Steuersignal von der Steuereinrichtung in eine zur Steuerung der Kapazitätsdiode geeignete Gleichspannung umsetzt.

Bei einer Integration geschalteter Festkondensatoren auf einem Halbleiterchip tritt das Problem auf, dass eine große Anzahl von Schaltern und Festkondensatoren integriert werden muss, um eine ausreichend große Auflösung der Frequenzabstimmung zu erreichen. Dies bedeutet eine Erhöhung der benötigten Fläche auf dem Halbleiterchip. Weiterhin treten parasitäre Kapazitäten der verwendeten Schalter störend in Erscheinung, so dass ein erzielbarer Abstimmbereich mit höherer Abstimmauflösung abnimmt.

Ausgehend hiervon liegt der Erfindung die Aufgabe zugrunde, einen Oszillator der eingangs genannten Art derart weiterzuentwickeln, dass seine Mittel zum Abstimmen der Frequenz seines Schwingkreises auf einem Halbleiterchip integriert werden können.

Diese Aufgabe wird bei dem oben erwähnten Oszillator dadurch gelöst, dass die Mittel zum Abstimmen der Frequenz des Schwingkreises von einer Amplituden-/Phasen-Anpassungseinrichtung gebildet werden, die ein dem Schwingkreis zugeführtes Korrektursignal erzeugt, das von dem Taktsignal abgeleitet ist und dessen Frequenz aufweist und die Steuereinrichtung derart ausgebildet ist, dass sie abhängig von einer Differenz zwischen einer gewünschten Taktfrequenz und einer aktuellen Taktfrequenz Phase und Amplitude des Korrektursignals mittels der Steuersignale bestimmt.

An die Stelle der im Stand der Technik eingesetzten Kapazitätsdioden oder geschalteten Kondensatoren tritt das von dem Taktsignal abgeleitete Korrektursignal. Wenn dieses Korrektursignal eine Phasenverschiebung zu dem von dem Schwingkreis bereitgestellten Taktsignal aufweist, wirkt seine Einkopplung in den Schwingkreis frequenzverändernd. Eine Größe der Frequenzveränderung wird dabei von einer Amplitude des Korrektursignals, der Phasenverschiebung zwischen Korrektursignal und Taktsignal sowie den Eigenschaften des eingesetzten Schwingquarzes bestimmt. Das Korrektursignal wirkt somit als aktiv erzeugte Impedanz, welche durch die Phase und die Amplitude des Korrektursignals gekennzeichnet ist.

Bevorzugt erhält die Amplituden-Phasen-Anpassungseinrichtung als ein Eingangssignal ein aktuelles Taktsignal des Schwingkreises. Dieses Taktsignal wird aufgrund der Steuersignale der Steuereinrichtung hinsichtlich seiner Amplitude und Phase so modifiziert, dass sich eine geeignete Regelung der von dem Schwingkreis bereitgestellten Taktfrequenz des Taktsignals ergibt.

Vorzugsweise ist die Amplituden-/Phasenanpassungseinrichtung zur Bereitstellung vorbestimmter Amplituden-/Phasenwerte für das Korrektursignal ausgebildet. Dies bedeutet, dass beispielsweise in einem Datenspeicher Wertepaare für Amplitude und Phase hinterlegt sind, die jeweils bestimmten Steuersignalen von der Steuereinrichtung zugeordnet sind. Ausgehend von einem gewünschten Regelergebnis kann dann die Auswahl einer geeigneten Amplitude und Phase des Korrektursignals über die Steuersignale der Steuereinrichtung vorgenommen werden.

Bevorzugt werden die Phase und die Amplitude des Korrektursignals von der Steuereinrichtung mittels digitaler Algorithmen bestimmt, die eine Güte des Schwingkreises berücksichtigen. Dem liegt zugrunde, dass quarzstabilisierte Schwingkreise eine hohe elektrische Güte besitzen, so dass sich eine Einkopplung des Korrektursignals in den Schwingkreis nicht unmittelbar auswirkt, sondern ein Einschwingvorgang erfolgt. Insofern bewirkt die elektrische Güte des quarzstabilisierten Schwingkreises eine Mittelung einer Korrekturwirkung durch das Korrektursignal, wenn dieses zeitvariant vorgesehen wird.

Es können für die Steuereinrichtung geeignete Algorithmen vorgesehen sein, welche auf eine filternde Wirkung des quarzstabilisierten Schwingkreises angepasst sind, so dass ggf. durch das Korrektursignal erzeugte Störungen minimiert werden können.

Bevorzugt wird das Korrektursignal dem Schwingkreis über den Schwingquarz zugeleitet. Die vorteilhafte mittelnde Wirkung der Quarzgüte kann nur erzielt werden, wenn das Korrektursignal in den Schwingquarz eingekoppelt wird. Dies kann durch Einprägung eines Stromes oder Addition einer Spannung direkt am Schwingquarz erfolgen.

Die Erfindung wird nachfolgend anhand eines Ausführungsbeispiels unter Bezugnahme auf die Zeichnungen noch näher erläutert. Es zeigen:
- Figur 1: ein Schaltbild eines Oszillators und
- Figur 2: zeitliche Verläufe bei dem Oszillator von Figur 1 auftretender Signale.

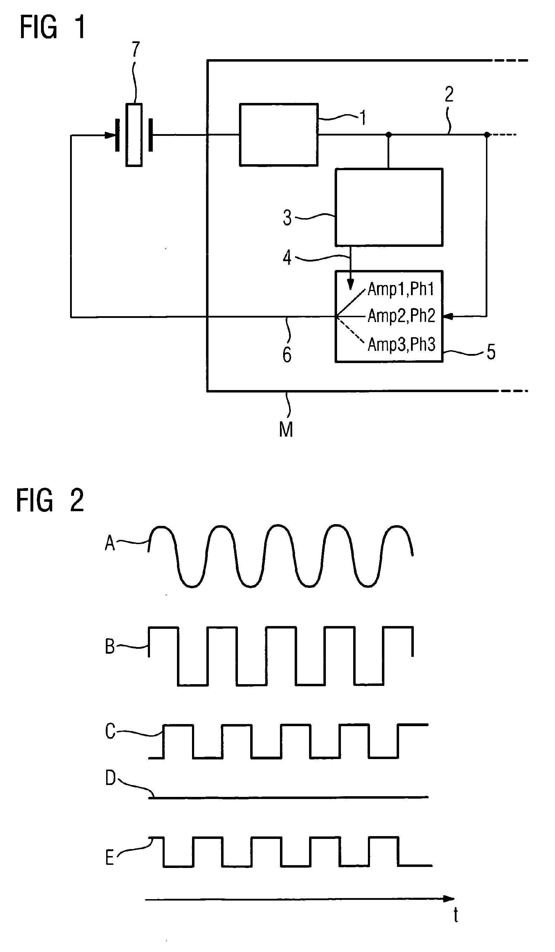

Das Schaltbild von Figur 1 zeigt einen Oszillator, der im wesentlichen auf einem Mikroprozessor M realisiert ist. Ein aktiver Teil 1 des Oszillators weist einen Schwingkreis zur Bereitstellung eines Resonanzfrequenzsignals sowie Mittel auf, die aus dem Resonanzfrequenzsignal ein für eine jeweilige Anwendung geeignetes Taktsignal 2 erzeugen. Bei dem Taktsignal 2 wird es sich in den meisten Fällen um ein Rechtecksignal handeln, an dessen Frequenzstabilität hohe Anforderungen gestellt werden, wenn es beispielsweise zur Taktvorgabe bei einem Mobilfunksystem eingesetzt wird.

Das Taktsignal 2 wird einer digitalen Steuereinrichtung 3 zugeführt. Das Taktsignal 2 liegt dabei an einem Eingang der Steuereinrichtung 3 an, der einer Frequenzregelfunktion der Steuereinrichtung 3 zugeordnet ist. Die Steuereinrichtung 3 ist derart ausgeführt, dass sie etwaige Abweichungen einer Frequenz des Taktsignals 2 von einer gewünschten Frequenz feststellt und, abhängig von einer erfassten Frequenzdifferenz, Steuersignale 4 für eine Phasen-/Amplitudenanpassungseinrichtung 5 erzeugt.

Die Amplituden-/Phasenanpassungseinrichtung 5 erhält als Eingangssignal das Taktsignal 2. In der Amplituden-/Phasenanpassungseinrichtung 5 sind vorbestimmte Wertepaare Amp1/Ph1; Amp2/Ph2; Amp3/Ph3 für Amplitude und Phase eines Korrektursignals 6 hinterlegt, das von der Amplituden-/Phasenanpassungseinrichtung 5, ausgehend von dem Taktsignal 2, erzeugt wird, so dass es von dem Taktsignal 2 abgeleitet ist.

Das Korrektursignal 6 wird über einen Schwingquarz 7, der zur Frequenzstabilisierung des Schwingkreises des aktiven Teils 1 des Oszillators dient, gerade diesem Schwingkreis (Resonanzkreis) zugeleitet. Das Korrektursignal 6 wirkt frequenzverändernd auf den Schwingkreis des Oszillators. Wenn das Korrektursignal 6 eine Phasenverschiebung zu dem Resonanzfrequenzsignal des Schwingkreises aufweist, wirkt es für den Schwingkreis wie eine aktiv erzeugte Impedanz, die durch die Phase und die Amplitude des Korrektursignals 6 bestimmt wird. Eine Größe der Frequenzveränderung für den Schwingkreis hängt im wesentlichen von einer Phasenverschiebung zwischen dem Korrektursignal 6 und dem Taktsignal 2, von der Amplitude des Korrektursignals 6 und von den Eigenschaften des Schwingquarzes 7 ab.

Die digitale Steuereinrichtung 3 arbeitet mit einem Algorithmus, der, abhängig von einer erfassten Frequenzabweichung für das Taktsignal 2, die Steuersignale 4 für die Amplituden-/Phasen-Anpassungseinrichtung bestimmt. Dabei ist jedes digitale Steuersignal 4 einem Phasen-/Amplitudenwertepaar der Phasen-/Amplituden-Anpassungseinrichtung 5 zugeordnet. Dabei berücksichtigt der Algorithmus, dass eine Güte des mit Hilfe des Schwingquarzes frequenzstabilisierten Schwingkreises einen Einschwingvorgang hervorruft, sobald sich eine Änderung des Korrektursignals 6 hinsichtlich Phase oder Amplitude ergeben hat. Der eingesetzte Algorithmus für die digitale Steuereinrichtung 3 ist auf eine filternde Wirkung des Schwingkreises angepasst, so dass durch das Korrektursignal 6 erzeugte Störungen minimiert werden können.

Figur 2 zeigt bei dem Oszillator von Figur 1 auftretende zeitliche Signalverläufe.

Eine Kurve A beschreibt ein Ausgangssignal des Schwingkreises des aktiven Teils 1 des Oszillators, d. h. ein Resonatorsignal. Eine Kurve B beschreibt das Taktsignal 2, das in Form eines Rechtecksignals vorliegt und aus dem Resonatorsignal gewonnen wird.

Die Kurven C, D und E beschreiben drei Alternativen für Signalformen des Korrektursignals 6. Bei der Kurve C beträgt eine Phasenverschiebung zwischen dem Taktsignal 2 und dem Korrektursignal 6 +90° nacheilend. Der gewählte Phasenwert entspricht einer minimalen Oszillatorfrequenz, die mit Hilfe der Steuereinrichtung 3 in Verbindung mit der Amplituden-/Phasenanpassungseinrichtung 5 zu erzeugen ist.

Die Kurve D zeigt einen Korrektursignalzustand mit der Amplitude 0. Das Vorsehen eines solchen Korrektursignalzustandes dient zur Erhöhung der Quantisierung.

Eine maximale Oszillatorfrequenz wird mit Hilfe des Korrektursignals 6 dann erreicht, wenn das Korrektursignal 6 den Verlauf der Kurve E zeigt, d. h. das Korrektursignal 6 ist gegenüber dem Taktsignal 2 um -90° voreilend phasenverschoben. Die Signalform der Kurve E lässt sich in einfacher Weise aus der Signalform der Kurve C ableiten, denn es handelt sich um deren invertierten Signalverlauf.

Beispielsweise bei einem nach dem GSM-Standard arbeitendem Mobilfunkendgerät beträgt eine Resonanzfrequenz des Schwingkreises des Oszillators 26 MHz. Für diesen Anwendungsfall könnte ein als das Korrektursignal 6 in den Schwingkreis eingeprägter Strom einen typischen Wert von etwa 100 µA aufweisen. Je nach Art der Injektion des Korrektursignals 6 kann allerdings auch ein höherer oder niedrigerer Strom erforderlich sein.

Mit Hilfe der drei in Figur 2 dargestellten Signalverläufe für das Korrektursignal 6 kann aufgrund des Vorliegens von Einschwingvorgängen durch eine wechselnde Auswahl aus den drei zur Verfügung stehenden Korrektursignalzuständen in einen Mittelwert jede beliebige Oszillatorfrequenz zwischen der minimal und der maximal erreichbaren Oszillatorfrequenz eingestellt werden.

Abschließend ist hervorzuheben, dass der gesamte Oszillator, ausgenommen der Schwingphase 7, in Digitaltechnik auf einem Mikroprozessor integriert werden kann, so dass die Vorteile digitaler Schaltungstechnik für die Realisierung des Oszillators zum Tragen kommen können.

## Patentansprüche

1. Oszillator mit
einem Schwingkreis zur Bereitstellung eines Taktsignals (2),
einem Schwingquarz (7) zur Frequenzstabilisierung des Schwingkreises,
einer digitalen Steuereinrichtung (3) zum Regeln einer Frequenz des Schwingkreises und
Mitteln zum Abstimmen der Frequenz des Schwingkreises aufgrund von Steuersignalen (4) von der Steuereinrichtung (3),
**dadurch gekennzeichnet, dass**
die Mittel zum Abstimmen der Frequenz des Schwingkreises von einer Amplituden-/Phasen-Anpassungseinrichtung (5) gebildet werden, die ein dem Schwingkreis zugeführtes Korrektursignal (6) erzeugt, das von dem Taktsignal (2) abgeleitet ist und dessen Frequenz aufweist und
die Steuereinrichtung (3) derart ausgebildet ist, dass sie abhängig von einer Differenz zwischen einer gewünschten Taktfrequenz und einer aktuellen Taktfrequenz (2) Phase und Amplitude des Korrektursignals (6) mittels der Steuersignale bestimmt.

2. Oszillator nach Anspruch 1,
**dadurch gekennzeichnet, dass**
die Amplituden-/Phasen-Anpassungseinrichtung (5) als ein Eingangssignal ein aktuelles Taktsignal (2) des Schwingkreises erhält.

3. Oszillator nach Anspruch 1 oder 2,
**dadurch gekennzeichnet, dass**
die Amplituden-/Phasenanpassungseinrichtung (5) zur Bereitstellung vorbestimmter Amplituden-/Phasenwerte für das Korrektursignal (6) ausgebildet ist.

4. Oszillator nach einem der Ansprüche 1 bis 3,
**dadurch gekennzeichnet, dass**
die Phase und die Amplitude des Korrektursignals (6) von der Steuereinrichtung (3) mittels digitaler Algorithmen bestimmt ist, die eine Güte des Schwingkreises berücksichtigen.

5. Oszillator nach einem der Ansprüche 1 bis 4,
**dadurch gekennzeichnet, dass**
das Korrektursignal (6) dem Schwingkreis über den Schwingquarz (7) zugeleitet ist.
